# EUROPÄISCHE PATENTSCHRIFT

(11) **EP 1 192 846 B1**
(45) Veröffentlichungstag und Bekanntmachung des Hinweises auf die Patenterteilung: **27.11.2002**
(21) Anmeldenummer: 00949143.2
(22) Anmeldetag: 30.06.2000
(51) Int. Cl.: H05K 7/20, G06F 1/20

(54) **KÜHLEINRICHTUNG FÜR EIN ELEKTRISCHES GERÄT**
DEVICE FOR COOLING AN ELECTRICAL APPLIANCE
DISPOSITIF DE REFROIDISSEMENT POUR UN APPAREIL ELECTRIQUE

(30) Priorität: 30.06.1999 DE 19930166
(43) Veröffentlichungstag der Anmeldung: 03.04.2002
(73) Patentinhaber: Fujitsu Siemens Computers GmbH, 81739 München (DE)
(72) Erfinder: GERSTNER, Robert, D-86163 Augsburg (DE); BAUMANN, Dieter, D-89437 Haunsheim (DE); NÖLDGE, Detlev, D-86199 Augsburg (DE); LINNE, Johannes, D-86447 Todtenweis (DE); AHN, Georg, D-86179 Augsburg (DE)
(74) Vertreter: Epping Hermann & Fischer
(86) Internationale Anmeldenummer: DE0002146
(87) Internationale Veröffentlichungsnummer: WO01003483

(56) Entgegenhaltungen:
- US-A- 4 817 865
- US-A- 5 121 291
- US-A- 5 764 506
- PATENT ABSTRACTS OF JAPAN vol. 1997, no. 03, 31. März 1997 (1997-03-31) & JP 08 316674 A (KOFU NIPPON DENKI KK), 29. November 1996 (1996-11-29)

## Beschreibung

Die Erfindung betrifft eine Kühleinrichtung für ein elektrisches Gerät gemäß dem Oberbegriff des Anspruchs 1.

Eine solche kühleinrichtung ist z.B. aus US-A-5 121 291 bekannt.

Kühleinrichtungen in elektrischen Geräten, beispielsweise in Computersystemen, sollen in der Weise realisiert sein, dass eine ausreichende Kühlung bei geringer Geräuschemission gegeben ist. Gleichzeitig sollen die Systemsicherheit gesteigert und die Kosten gesenkt sein.

Von Intel, Microsoft und Toshiba ist eine ACPI-Spezifikation herausgegeben worden, die einige zu diesem Problem passende grundsätzliche Lösungsansätze beschreibt. ACPI steht für "Advanced Configuration and Power Interface", und ist eine Schnittstellenspezifikation zum Informationsaustausch zwischen einer PC-Hardware, dem zugehörigen Betriebssystem und den zugehörigen Peripheriegeräten. Die Spezifikation legt ein Format fest, in dem Betriebssystem, Motherboard-Hardware und Peripheriegeräte wie CD-ROM-Laufwerk, Festplatten usw. gegenseitig Daten über den Energieverbrauch austauschen können. Das Hauptziel von ACPI ist, das Operating System Directed Power Management (OSPM) zu ermöglichen, bei dem das Betriebssystem Zugriff auf alle Power-Management-Funktionen hat und damit den Energieverbrauch der einzelnen Geräte präzise an den jeweiligen Bedarf anpassen kann (siehe Internet, Adresse: http://www.andygrove.com/deutsch/mobile/mobilePCs/acpimen.htm).

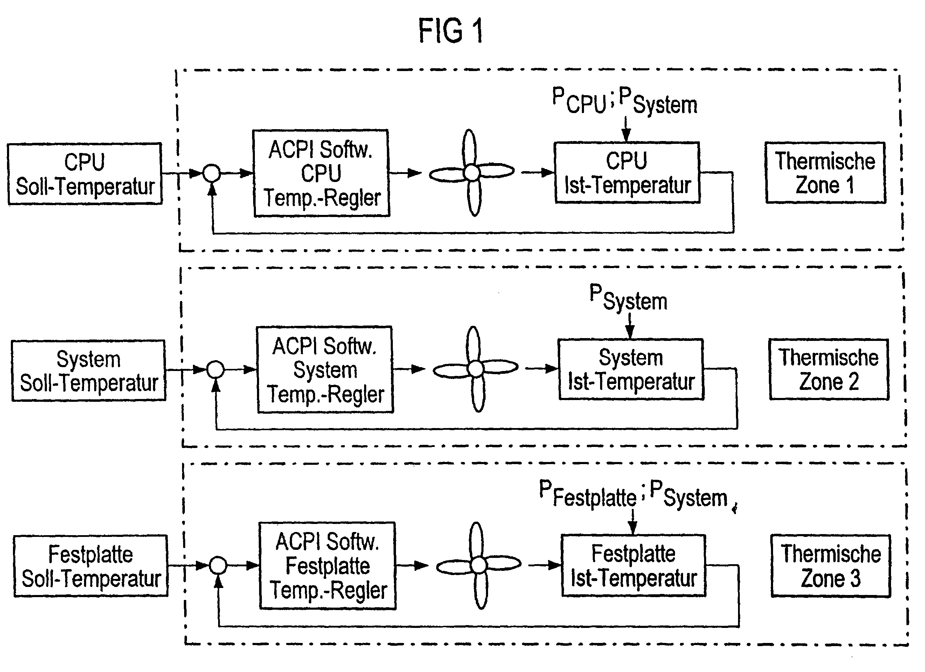

Ein Problem der ACPI-Spezifikation ist, dass sie sich, wie in der Figur 1 dargestellt, auf einzelne thermisch abgeschlossene Zonen bezieht, die jeweils aus einem Sensor und einer zugeordneten Kühlmethode, welche wiederum aus mehreren Einheiten (z.B. Lüfter) bestehen kann, bestehen. Der Regelkreis einer Kühlmethode besteht aus dem Stellglied zur Kühlung (z.B. Lüfter bzw. CPU Takt- Reduzierung/Modulierung), der Istwerterfassung (Temperatursensor), der Störgröße (z.B. Verlustleistung der CPU) und dem Regler. Bei ACPI wird der Regler als Bestandteil des Betriebssystems in Software auf der CPU- Einheit des Computersystems ausgeführt. Dies setzt ein vollständig funktionsfähiges Computersystem voraus. Das heißt, der Kühlregelkreis ist nur solange intakt, wie das zu kühlende System funktioniert.

In dem nach ACPI implementierten Beispiel gemäß der Figur 1 besteht das System aus drei voneinander unabhängigen Zonen. Ein weiteres Problem in diesem Zusammenhang ist, dass thermische Wechselwirkungen zwischen den Zonen nicht erfasst werden. Sie können daher auch nicht berücksichtigt werden.

Aufgabe der vorliegenden Erfindung ist, eine verbesserte Kühleinrichtung für ein elektrisches Gerät anzugeben, die eine ausreichende Kühlung bei geringer Geräuschemission gewährleistet und dabei Grundlage dafür ist, dass Kühlungsmittel verkleinerbar oder gänzlich einsparbar sind, dass eine universelle Anpassung an verschiedene Gerätekonfigurationen durchführbar ist oder dass der Kühlkreislauf noch funktionsfähig ist, wenn das zu kühlende System ausgefallen ist. Eine weitere Aufgabe ist, eine Temperaturkontrolleinheit für eine solche Kühleinrichtung anzugeben.

Diese Aufgabe wird durch eine Kühleinrichtung gelöst, die die Merkmale des Anspruchs 1 aufweist.

Die erfindungsgemäße Kühleinrichtung nützt in vorteilhafter Weise den Umstand aus, dass zwischen den einzelnen thermischen Zonen Wechselwirkungen bestehen. Durch die Wechselwirkungen hat die Kühlmethode einer thermischen Zone Einfluss auf eine andere thermische Zone. Dieser Sachverhalt wird dahingehend vorteilhaft ausgenutzt, dass mit den Kühlungsmitteln der einen thermischen Zone die Kühlungsmittel der anderen thermischen Zone unterstützt werden. Möglicherweise können dann Kühlungsmittel sogar gänzlich entfallen. Damit dieser Vorteil erhalten wird, werden zueinander in Wechselwirkung stehende thermische Zonen zu einer einheitlichen thermischen Zone zusammengefasst, wodurch sich die einzelnen darin vorkommenden Kühlungsmittel gegenseitig ergänzen oder ersetzen können. Ein solche Kühleinrichtung hat weiter den Vorteil, dass sie Grundlage für weitere vorteilhafte Ausgestaltungen ist.

Weitere vorteilhafte Ausgestaltungen der Erfindung sind in den Unteransprüchen angegeben.

Danach sind beispielsweise Maximalwertbildner und/oder wenigstens eine Zuordnungsmatrix verwendet.

Maximalwertbildner ermöglichen die Ermittlung einer Stellgröße anhand von Informationen mehrerer Regelglieder, von denen das, das den kritischsten Fall anzeigt, letztlich zur Regelung herangezogen wird. Damit ist sichergestellt, dass immer die kritischste Temperatur die Stellgröße bestimmt.

Die Zuordnungsmatrix ermöglicht einerseits die flexible Zuordnung von mehr als einem Regelglied (z.B. für CPU- und Systemtemperatur) pro Stellglied (z.B. Lüfter). Die Zuordnungsmatrix erlaubt andererseits auch die flexible Zuordnung von einem Regelglied auf mehrere Stellglieder.

Die Kombination einer flexiblen Zuordnungsmatrix mit Maximalwertbildnern ermöglicht eine universelle Zusammenschaltung von in einem System vorhandenen Regel- und Stellgliedern, so dass die vorgeschlagene Kühleinrichtung für alle Systemkonfigurationen mit den obigen Vorteilen einsetzbar ist.

Eine Ausgestaltung der Erfindung gemäß dem Anspruch 6 hat den Vorteil, dass die Regelung der Kühlungsfunktionen auch dann vollständig gegeben ist, wenn das Betriebssystem bzw. die CPU-Einheit und die zugehörigen Komponenten wie Chipset, Speicher etc. eines beispielsweise angenommenen Computersystems als elektrisches Gerät gestört sind. Mit der Erfindung wird daher eine Steigerung der Zuverlässigkeit eines betreffenden Systems erreicht. Des weiteren ist die Kühlungsfunktion auch dann gewährleistet, wenn das Betriebssystem keine Power Management Funktionen wie beispielsweise ACPI unterstützt.

Grund für die vorteilhafte Ausgestaltung ist, dass die Regelstrecken von den zu überwachenden thermischen Zonen entkoppelt sind. Es übernimmt nicht mehr die zu kühlende Einheit, wie zum Beispiel die CPU eines Computersystems und deren Komponenten, die Überwachung und Regelung der Kühlung, sondern es erfolgt eine von dem zu kühlenden System unabhängige Überwachung und Regelung der Kühlung.

Werden Funktionen der Überwachung und Kühlungsregelung in einer eigenständigen Einheit realisiert, können damit ursprünglich nicht mit einer Kühleinrichtung nach einem der Ansprüche 1 bis 5 ausgelegte Kühleinrichtungen nach dem Prinzip dieser Kühleinrichtung betrieben werden. Außerdem sind für solche Einheiten kostengünstig beispielsweise ASICs oder Mikrokontroller verwendbar. Die ASICs oder Mikrokontroller müssen dabei nicht ausschließlich für die Überwachung und Kühlungsregelung konzipiert sein.

Nachfolgend werden anhand einer Zeichnung weitere Erläuterungen gemacht und zwei Ausführungsbeispiele der Erfindung näher beschrieben. Im einzelnen zeigen:
- Figur 1: eine nach thermische Zonen unterteilte Systemstruktur eines elektrischen Geräts, gemäß dem Stand der Technik,
- Figur 2: eine nach thermische Zonen unterteilte Systemstruktur eines elektrischen Geräts mit sich überlappenden thermischen Zonen, gemäß dem Stand der Technik,
- Figur 3: eine nach thermische Zonen unterteilte Systemstruktur eines elektrischen Geräts mit einer eingeschlossenen thermischen Zone, gemäß dem Stand der Technik,
- Figur 4: eine prinzipielle Systemstruktur gemäß der Erfindung,
- Figur 5: ein erstes Ausführungsbeispiel gemäß der Erfindung, und
- Figur 6: ein zweites Ausführungsbeisbeispiel gemäß der Erfindung.

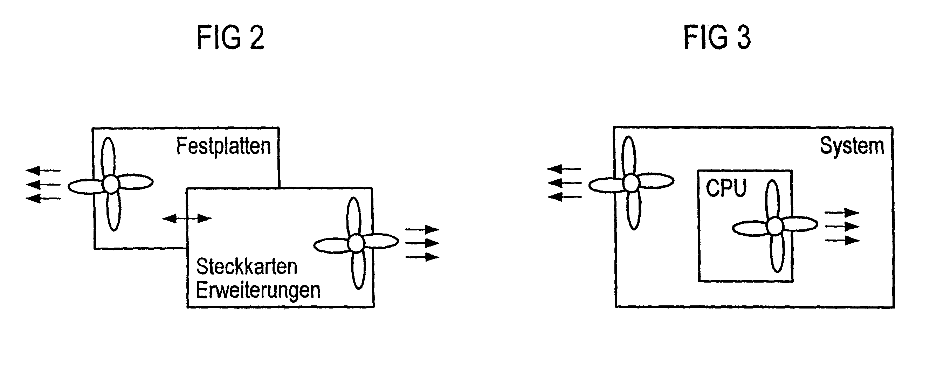

Figur 2 zeigt ein Beispiel für sich überlappende thermische Zonen. Figur 3 zeigt ein Beispiel für eingeschlossene thermische Zonen.

In der Realität treten überlappende bzw. eingeschlossene thermische Zonen, wie sie in den Figuren 2 und 3 prinzipiell dargestellt sind, häufig auf. Hierbei kommt es zu thermischen Wechselwirkungen zwischen den einzelnen thermischen Zonen.

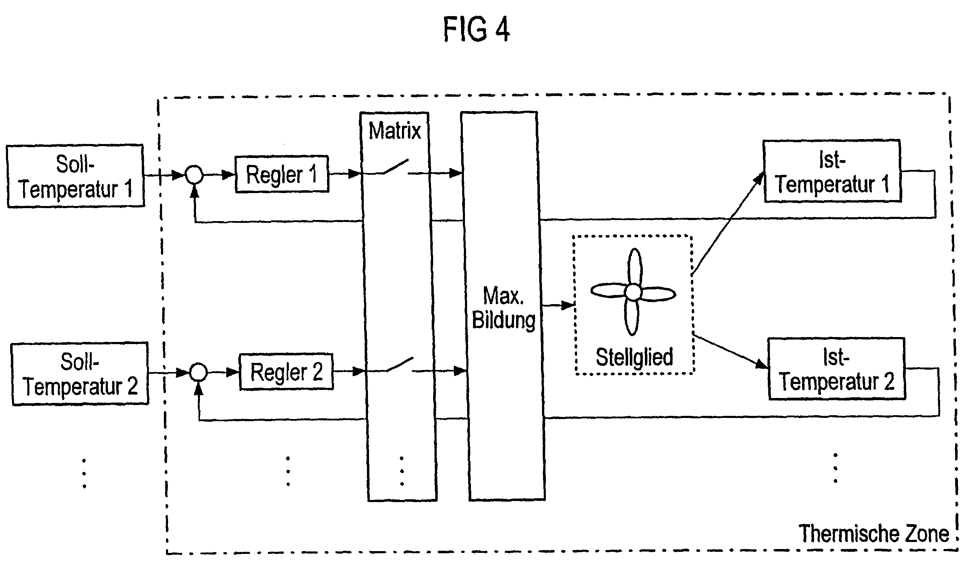

Figur 4 zeigt das Schema einer erfindungsgemäßen Kühleinrichtung für ein einziges Stellglied. Mit einer solchen Kühleinrichtung kann im Gegensatz zu anderen Prinzipien (z.B. ACPI) eine thermische Wechselwirkung zwischen den unterschiedlichen thermischen Zonen berücksichtigt werden. Hierzu werden alle thermischen Zonen mit Wechselwirkungen zu einer thermischen Zone reduziert, in welche alle Temperatursensoren (Istwerterfassung) und Kühlmethoden (Stellglieder) eingeschlossen sind. Die Berücksichtigung der Wechselwirkung wird erreicht, da bei einer Kühleinrichtung gemäß der Figur 4 nicht nur ein einziges Regelglied, sondern auch mehrere Regelglieder auf ein Stellglied Einfluß nehmen können. Die Realisierung sieht hierfür eine flexible Zuordnungsmatrix für die Regelglieder und einen Maximalwertbildner für eine Maximalwertbildung für ein jedes Stellglied vor. Damit wird den praktischen Anforderungen von überlappenden bzw. eingeschlossenen thermischen Zonen Rechnung getragen.

Das hat den vorteilhaften Effekt, dass oft die Anzahl der nötigen Lüfter reduziert werden kann, wodurch die Kosten und die Geräuschemission gesenkt werden.

Ein weiterer Vorteil ist, dass in Systemen mit mehreren Kühlmethoden, durch die Berücksichtigung der Wechselwirkungen der Aufwand für jede einzelne Kühlmethode reduziert werden kann. Ein Beispiel für mehrere Kühlmethoden ist ein System mit einer "eingeschlossenen thermischen Zone". Ein solches System ist beispielsweise eine CPU mit aufgesetztem Lüfter in einem PC-Gehäuse mit Stromversorgung mit integriertem Lüfter. Anstatt die Kühlmethode für die eingeschlossene Zone (CPU-Lüfter) für den schlimmsten Fall auszulegen (minimaler Luftdurchsatz im System) wird bei übermäßiger Erhöhung der CPU-Temperatur auch die Drehzahl des Lüfters in der Stromversorgung erhöht. Dadurch wird die Temperatur im elektrischen Gerät gesenkt und die Strömungsgeschwindigkeit auch im Bereich der CPU erhöht, wodurch die Kühlung der CPU verbessert wird. Durch passende Wahl der Parameter können auch hier die Kosten und die Geräuschemission gesenkt werden.

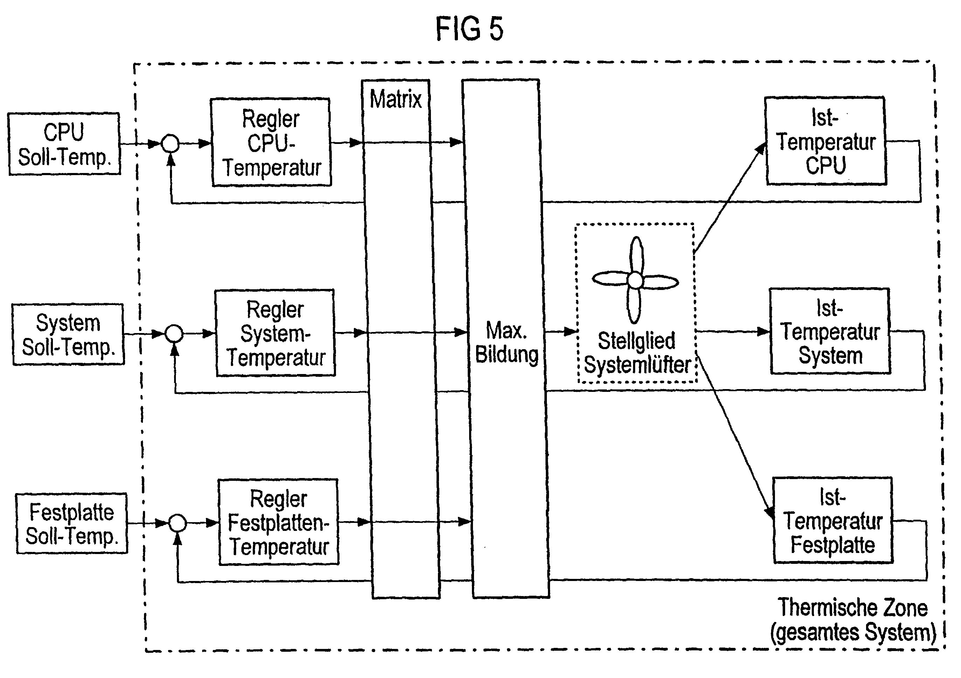

In der Figur 5 ist ein Ausführungsbeispiel gezeigt, bei dem das Kühlen eines PC-Systems mit nur einem Lüfter und 3 Sensoren erfolgt. In diesem Beispiel dient die flexible Zuordnungsmatrix lediglich dem Zuschalten der drei Regelglieder auf die Maximalwertbildung für das Stellglied "Systemlüfter". Die drei thermischen Zonen (CPU, Festplatte und System) haben eine Wechselwirkung. Der als Stellglied fungierende Systemlüfter wirkt auf alle thermischen Zonen. Diese Anordnung wird deshalb zu einer thermischen Zone "gesamtes System" zusammengefaßt und die Lüfterdrehzahl ergibt sich durch eine Maximalwertbildung aus den drei Reglerausgangsgrößen. In anderen Worten, die kritischste Temperatur bestimmt die Drehzahl des Lüfters. Durch die Reduzierung auf nur einen Lüfter im System wird eine Minimierung der Kosten und des Lüftergeräusches erreicht.

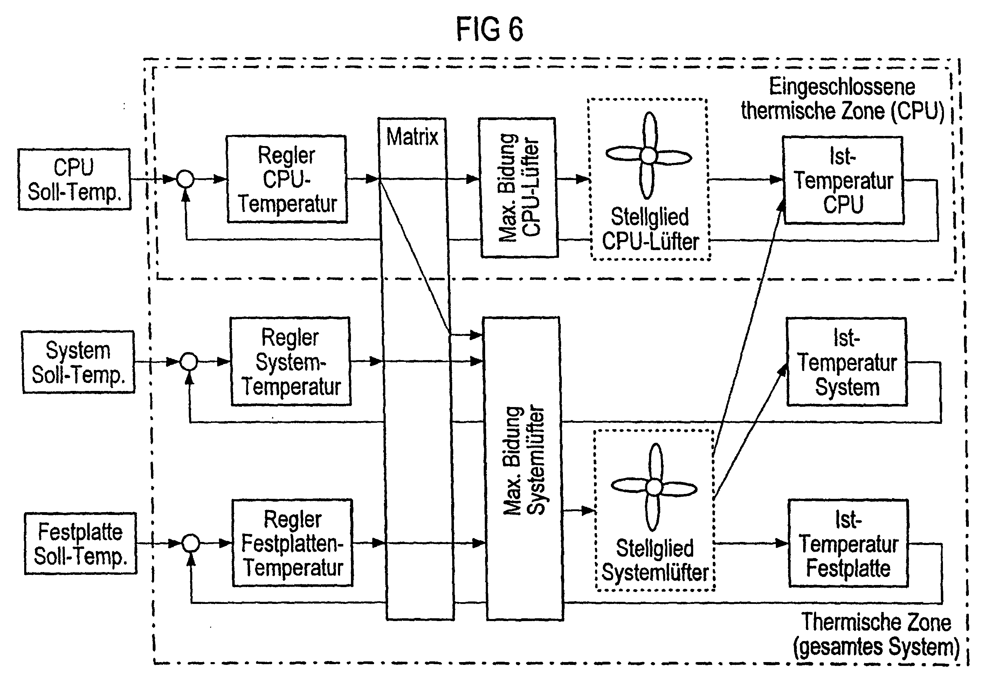

In der Figur 6 ist ein Ausführungsbeispiel bezüglich dem Kühlen eines Systems mit der CPU als thermischen "Hot Spot" mit eigenem Lüfter gezeigt. In einem solchen, typischen Computersystem kann es sinnvoll sein, eine zusätzliche Kühlmethode (Lüfter, Heruntertakten, ....) für den "Hot Spot" CPU vorzusehen, da der Systemlüfter bzw. der Lüfter in der Stromversorgung zwar einen Einfluß auf die CPU-Temperatur hat, aber räumlich zu weit entfernt ist, oder der Luftstrom nicht gezielt auf die CPU gelenkt werden kann.

In diesem Beispiel handelt es sich bei der Kombination aus CPU und CPU-Lüfter um eine eingeschlossene thermische Zone, welche eine Wechselwirkung mit der umschließenden thermischen Zone "gesamtes System" hat.

Bei dem Regelkreis für das Stellglied "CPU-Lüfter" handelt es sich um einen klassischen Regler, wie er auch mit ACPI realisert werden kann. Da hier nur der Regler "CPU-Temperatur" Einfluß auf das Stellglied "CPU-Lüfter" hat, wäre keine Maximalwertbildung für dieses Stellglied nötig. Diese universelle Anordnung gestattet es jedoch, jederzeit den Einfluß eines weiteren Regelgliedes mittels der flexiblen Zuordnungsmatrix auf das Stellglied zu schalten.

Die drei thermischen Zonen (CPU, Festplatte und System) haben eine Wechselwirkung. Der als Stellglied fungierende Systemlüfter wirkt auf alle drei thermischen Zonen. Diese Anordnung wird deshalb zu einer thermischen Zone "gesamtes System" zusammengefaßt und die Lüfterdrehgeschwindigkeit ergibt sich durch eine Maximumsbildung der drei Reglerausgangsgrößen. Diese Maximumsbildung stellt wie im vorausgegangenen Beispiel sicher, dass sich die Drehzahl des Systemlüfters an der kritischsten Temperatur orientiert. Die flexible Zuordnungsmatrix ermöglicht in diesem Fall, dass das Regelglied "CPU-Temperatur" Einfluß auf beide Stellglieder (CPU-, Systemlüfter) hat.

Da beide Kühlmethoden einen Einfluß auf die CPU-Temperatur haben, wird hierdurch erreicht, dass die Kühlmethode der eingeschlossenen Zone durch die Kühlmethode der umschließenden Zone gezielt entlastet wird. Anstatt die Kühlmethode für die eingeschlossene Zone (CPU-Lüfter) für den schlimmsten Fall auszulegen (minimaler Luftdurchsatz im System, bzw. maximale Systeminnentemperatur) wird bei übermäßiger Erhöhung der CPU-Temperatur auch die Drehzahl des System-Lüfters erhöht. Durch passende Wahl der Regel-Parameter kann hier der CPU-Lüfter schwächer ausgelegt werden. Hierdurch werden wiederum Kosten und Geräuschemission reduziert.

## Patentansprüche

1. Kühleinrichtuhg für ein elektrisches Gerät mit
- zueinander Wechselwirkungen aufweisenden thermischen Zonen, wobei jede der thermischen Zonen eine Wärmequelle und einen Temperatursensor aufweist, und
- mindestens zwei Kühlungsmitteln,
- wobei jeder thermischen Zone ein mit dem Temperatursensor verbundenes Regelglied zur Ansteuerung der mindestens zwei Kühlungsmittel zugeordnet ist und
- wobei Ausgänge mehrerer Regelglieder mit den mindestens zwei Kühlungsmitteln verbindbar sind,
**dadurch gekennzeichnet, dass** zwischen mehrere Regelglieder und die mindestens zwei Kühlungsmittel eine Zuordnungsmatrix geschaltet ist, durch die Regelglieder mit den mindestens zwei Kühlungsmitteln verbindbar sind.

2. Kühleinrichtung nach Anspruch 1,
**dadurch gekennzeichnet, dass** zwischen mehrere Regelglieder und das mindestens eine Kühlungsmittel ein Maximalwertbildner zur Erkennung krischer Zustände geschaltet ist.

3. Kühleinrichtung nach Anspruch 1 oder 2,
**dadurch gekennzeichnet, dass** das elektrische Gerät ein Computersystem und die Kühlungsmittel Lüfter sind.

4. Kühleinrichtung nach einem der Ansprüche 1 bis 3,
**dadurch gekennzeichnet, dass** die Regelglieder mit einem ASIC- und/oder Mikrokontroller-Baustein bzw. als Teil davon realisiert sind.

## Claims

1. Device for cooling an electrical appliance, with
- thermal zones having mutual interactions, each of the thermal zones having a heat source and a temperature sensor, and
- at least two cooling means,
- each thermal zone being allocated a control element which is connected to the temperature sensor and is provided for activating the at least two cooling means and
- it being possible for outputs of a number of control elements to be connected to the at least two cooling means,
**characterized in that** arranged between a number of control elements and the at least two cooling means is an allocation matrix, by which the control elements can be connected to the at least two cooling means.

2. Cooling device according to Claim 1, **characterized in that** arranged between a number of control elements and the at least one cooling means is a maximum-value forming unit for detecting critical states.

3. Cooling device according to Claim 1 or 2, **characterized in that** the electrical appliance is a computer system and the cooling means are fans.

4. Cooling device according to one of Claims 1 to 3, **characterized in that** the control elements are implemented by an ASIC and/or microcontroller module or as part thereof.

## Revendications

1. Dispositif de refroidissement pour un appareil électrique comportant
• des zones thermiques présentant des interactions les unes avec les autres, chaque zone thermique présentant une source de chaleur et un détecteur de température, et
• au moins deux moyens de refroidissement,
• dans lequel à chaque zone thermique est associé un élément fonctionnel du régulateur lié au détecteur de température pour commander les au moins deux moyens de refroidissement et
• dans lequel les sorties de plusieurs éléments fonctionnels du régulateur peuvent être reliées aux moyens de refroidissement au moins au nombre de deux,
**caractérisé en ce qu'**une matrice d'association, par laquelle des éléments fonctionnels du régulateur peuvent être reliés aux moyens de refroidissement au moins au nombre de deux, est connectée entre plusieurs éléments fonctionnels du régulateur et les moyens de refroidissement au moins au nombre de deux.

2. Dispositif de refroidissement selon la revendication 1 **caractérisé en ce qu'**un indicateur de valeur maximale pour reconnaître des états critiques est connecté entre plusieurs éléments fonctionnels du régulateur et le au moins un moyen de refroidissement.

3. Dispositif de refroidissement selon la revendication 1 ou 2 **caractérisé en ce que** l'appareil électrique est un système informatique et les moyens de refroidissement sont des ventilateurs.

4. Dispositif de refroidissement selon l'une des revendications 1 à 3 **caractérisé en ce que** les éléments fonctionnels du régulateur sont réalisés avec un composant ASIC et/ou de microcontrôleur ou en tant qu'une partie d'entre eux.
